# EUROPEAN PATENT APPLICATION

(11) **EP 2 650 913 A1**
(43) Date of publication of application: **16.10.2013**
(21) Application number: 12751926.2
(22) Date of filing: 19.01.2012
(51) Int. Cl.: H01L 21/31, C23C 16/44, H01L 21/205

(54) **DRY CLEANING METHOD**

(30) Priority: 03.03.2011 JP 2011046149
(71) Applicant: Central Glass Company, Limited, Yamaguchi 755-0001 (JP)
(72) Inventor: UMEZAKI, Tomonori, (JP); TAKEDA, Yuta, (JP)
(74) Representative: Manitz, Finsterwald & Partner GbR
(86) International application number: PCT/JP2012/051025
(87) International publication number: WO 2012/117758

(57) **Abstract**

Disclosed is a dry cleaning method for removing a composition represented by a compositional formula of MgₐZn_{b}OH_{c} (0≤a≤1, 0≤b≤1, 0≤c≤1, and 0.5≤a+b≤1), which accumulates in a film formation chamber or in an exhaust pipe of an apparatus for forming a composition represented by a compositional formula of Mg_{X}Zn_{1-X}O (0≤x≤1) into a film, by using a cleaning gas. This method is characterized by that a cleaning gas containing β-diketone is used and that the composition is removed by reacting the composition accumulated with the cleaning gas at a temperature of from 100 °C to 400 °C. It is possible by this method to remove the composition without opening the apparatus.

## Description

### TECHNICAL FIELD

The present invention relates to a dry cleaning method for removing a composition represented by MgₐZn_{b}OH_{c} (0≤a≤1, 0≤b≤1, 0≤c≤1, and 0.5≤a+b≤1), which accumulates in an apparatus that forms zinc oxide, which is used as a transparent electrode material or a semiconductor material, or Mg_{X}Zn_{1-X}O (0≤x≤1), which is used as a new-type buffer layer of chalcopyrite-based solar cells, into a film.

### BACKGROUND OF THE INVENTION

Zinc oxide is a compound that attracts in recent years an attention as a transparent electrode material or a semiconductor material. Furthermore, Mg_{X}Zn_{1-X}O (0≤x≤1) is a composition that attracts in recent years an attention as a new-type buffer layer of chalcopyrite-based solar cells. In the case of depositing these magnesium and zinc oxide films, there are used a MOCVD method and a sputtering method, in which Zn(C₁₁H₁₉O₂)₂, Mg(C₁₁H₁₉O₂)₂, etc. are used as the raw materials. In a film formation apparatus using the above methods, however, if there is conducted a film formation treatment of magnesium or zinc oxide film, a composition represented by a compositional formula of MgₐZn_{b}OH_{c} (0≤a≤1, 0≤b≤1, 0≤c≤1, and 0.5≤a+b≤1) as an unnecessary deposit is attached to an inner wall and a wafer stage of a film formation chamber and an inner wall of an exhaust pipe, etc. of the apparatus. The increase of these unnecessary deposits will become a cause of particles. This causes worsening of the device performance.

Now, in order to remove these unnecessary deposits, there is conducted a physical washing by disassembling the apparatus and mechanically removing the attached unnecessary deposit, or a wet cleaning by an immersion in an acid or an alkali reagent for the removal. In these methods, however, there are a problem that, since the apparatus is once opened to the atmosphere, dust gets into the apparatus and contaminates the same, a problem that time and labor are necessary in the disassembling operation itself, and the like. In order to solve such problem, in recent years there has been tried a dry cleaning of zinc oxides by dry cleaning methods. For example, there has been proposed a method by etching a zinc oxide film by a reactive ion etching (RIE) method against the zinc oxide film in a mixed gas atmosphere containing methane and hydrogen (Patent Publication 1). Furthermore, there has been proposed a method in which zinc oxide is reduced under high temperatures by using a reducing gas such as CO, then the generated zinc vapor is oxidized again, and then the zinc oxide is recovered in the outside of the apparatus (Patent Publication 2).

We have not found reports of a dry cleaning by the dry cleaning method with respect to MgO and MgₐZn_{b}OH_{c} (0≤a≤1, 0≤b≤1, 0≤c≤1, and 0.5≤a+b≤1).

### PRIOR ART PUBLICATIONS

### PATENT PUBLICATIONS

Patent Publication 1: Japanese Patent Application Publication 2010-3872.
Patent Publication 2: Japanese Patent Application Publication Heisei 5-254998.

### SUMMARY OF THE INVENTION

In the method described in the above-mentioned Patent Publication 1, a plasma environment is necessary, and it is difficult to conduct a zinc oxide etching on the reactor wall or in the exhaust pipe where radicals and ion species resulting from plasma-enhancement hardly reach. Furthermore, in the method described in the above-mentioned Patent Publication 2, a high-temperature environment of 1000 °C or higher is necessary, and it is not practical in the case of assuming a deposit cleaning in the film formation apparatus.

In an apparatus for forming a composition represented by a compositional formula of Mg_{X}Zn_{1-X}O (0≤x≤1) into a film, when the composition is formed into a film, there accumulates a composition represented by a compositional formula of MgₐZn_{b}OH_{c} (0≤a≤1, 0≤b≤1, 0≤c≤1, and 0.5≤a+b≤1) on a section where the film formation is unnecessary, such as an inner wall and a wafer stage of a film formation chamber, an inner wall of an exhaust pipe, etc. of the film formation apparatus. Therefore, it is an object of the present invention to provide a dry cleaning method by removing this deposit at low temperatures.

As a result of repeating an eager study, the present inventors have found that a reaction of a β-diketone-containing cleaning gas at a temperature of from 100 °C to 400 °C against a composition represented by a compositional formula of MgₐZn_{b}OH_{c} (0≤a≤1, 0≤b≤1, 0≤c≤1, and 0.5≤a+b≤1) can efficiently remove the composition represented by the above-mentioned MgₐZn_{b}OH_{c} (0≤a≤1, 0≤b≤1, 0≤c≤1, and 0.5≤a+b≤1), thereby reaching the present invention.

That is, the present invention provides, in a dry cleaning method for removing a composition represented by a compositional formula of MgₐZn_{b}OH_{c} (0≤a≤1, 0≤b≤1, 0≤c≤1, and 0.5≤a+b≤1), which accumulates in a film formation chamber or in an exhaust pipe of an apparatus for forming a composition represented by a compositional formula of Mg_{X}Zn_{1-X}O (0≤x≤1) into a film, by using a cleaning gas, a dry cleaning method (first method) characterized by that a cleaning gas containing β-diketone is used and that the composition is removed by reacting the composition accumulated with the cleaning gas at a temperature of from 100 °C to 400 °C.

The first method may be a dry cleaning method (second method) characterized by that the β-diketone is hexafluoroacetylacetone or trifluoroacetylacetone.

The first or second method may be a dry cleaning method (third method) characterized by that the cleaning gas contains at least one gas selected from the group consisting of He, Ar, N₂, and O₂.

### ADVANTAGEOUS EFFECT OF THE INVENTION

It becomes possible by the dry cleaning method of the present invention to remove a composition represented by a compositional formula of MgₐZn_{b}OH_{c} (0≤a≤1, 0≤b≤1, 0≤c≤1, and 0.5≤a+b≤1), which accumulates in a film formation chamber or in an exhaust pipe, at a low temperature of 400 °C or lower.

### BRIEF DESCRIPTION OF THE DRAWINGS

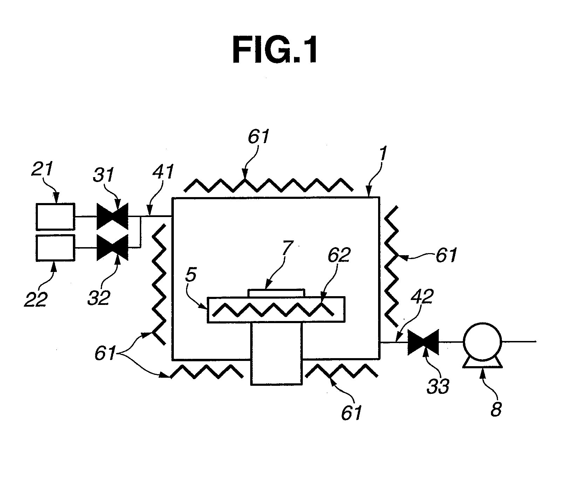

Fig. 1 shows a system diagram of an apparatus used in a test.

### DETAILED DESCRIPTION

The removal target in the present invention is a composition represented by MgₐZn_{b}OH_{c} (0≤a≤1, 0≤b≤1, 0≤c≤1, and 0.5≤a+b≤1). Specifically, it is possible to mention ZnO, MgO, Mg_{0.5}Zn_{0.5}O, Mg_{0.5}Zn_{0.5}OH_{0.1}, etc.

In an apparatus (e.g., CVD apparatus, sputtering apparatus, and vacuum deposition apparatus) for forming a composition represented by a compositional formula of Mg_{X}Zn_{1-X}O (0≤x≤1) into a film, when the composition is formed into a film on a substrate, a composition represented by a compositional formula of MgₐZn_{b}OH_{c} (0≤a≤1, 0≤b≤1, 0≤c≤1, and 0.5≤a+b≤1) accumulates, as an unnecessary deposit, in a place except the substrate, such as a film formation chamber or an exhaust pipe of the film formation apparatus. Therefore, the present invention provides a method for removing this deposit.

In the dry cleaning method of the present invention, it is necessary that the cleaning gas contains at least one β-diketone. As β-diketone, it is possible to mention, for example, hexafluoroacetylacetone, trifluoroacetylacetone, acetylacetone, dipivaloylmethane (H-DPM), etc. In particular, hexafluoroacetylacetone and trifluoroacetylacetone are preferable due to their possibility of a high-speed etching. The rate of etching the deposit increases with the increase of the concentration of β-diketone contained in the cleaning gas. If there is a fear of the possibility that liquefaction occurs in the chamber due to a low vapor pressure of β-diketone used, it is preferable to suitably adjust the concentration by a diluting gas. Furthermore, in view of the efficiency with the amount of the cleaning gas used, it is preferable that the concentration of β-diketone is from 10 volume % to 80 volume %.

In the cleaning gas, together with the above-mentioned β-diketone, at least one gas selected from the group consisting of inert gases, such as He, Ar and N₂, or O₂ may be contained, and its concentration is not particularly limited, either.

As to the temperature during the cleaning, it is preferable that the temperature of the deposit as the removal target is from 100 °C to 400 °C. In particular, it is desirable to be from 150 °C to 400 °C, in order to obtain a higher etching rate.

The pressure of the inside of the chamber during the cleaning is not particularly limited. It is preferable to be from 0.1 kPa to 101.3 kPa, which is normally used in the film formation.

By conducting the dry cleaning under the above-mentioned conditions, it becomes possible to remove a composition represented by MgₐZn_{b}OH_{c} (0≤a≤1, 0≤b≤1, 0≤c≤1, and 0.5≤a+b≤1).

### EXAMPLES

Fig. 1 is a system diagram of a CVD apparatus used in the present test. A film formation chamber 1 is equipped with a stage 5 for supporting a wafer for the film formation. The outside of the film formation chamber 1 and the inside of the stage 5 are equipped with heaters 61, 62. A gas pipe 41 for introducing gas and a gas pipe 42 for exhausting gas are connected to the film formation chamber 1. A β-diketone supply system 21 and a diluting gas supply system 22 are connected to the gas pipe 41 via valves 31, 32. A vacuum pump 8 is connected to the gas pipe 42 via valve 33. The pressure of the inside of the film formation chamber 1 is controlled by the valve 33, based on the indicated value of a pressure gauge (omitted in the drawings) attached to the film formation chamber 1.

In the present examples, as a deposit sample 7, an MgₐZn_{b}OH_{c} film (0≤a≤1, 0≤b≤1, 0≤c≤1, and 0.5≤a+b≤1) [shape: a piece of 3 cm x 3 cm] formed by 2 µm on a Si wafer was placed on the stage 5 and subjected to a cleaning test. Furthermore, a thermocouple for measuring the temperature of the deposit sample 7 was installed between the deposit sample 7 and the stage 5 (omitted in the drawings).

The amount of etching of the film was calculated from the film reduction by measuring the change of the film thickness before and after the test through a cross section SEM observation. The etching rate is the value obtained by dividing the film reduction by the etching time. The etching time was defined as the time from the start of cleaning gas introduction to the end of the introduction and set at 3 minutes in the present example.

Next, the operation method is explained. The film formation chamber 1 and the gas pipes 41, 42 are evacuated until less than 10 Pa. Then, the pressure of the inside of the film formation chamber 1 and the temperatures of the heaters 61, 62 are set at predetermined values. After confirming that heaters 61, 62 have reached the predetermined values, the valves 31, 32 are opened, and the cleaning gas is introduced from the β-diketone supply system 21 and the diluting gas supply system 22. Furthermore, the temperature of the deposit sample 7 is measured by the thermocouple installed. After the lapse of the predetermined time (three minutes), the introduction of the cleaning gas was stopped, and the inside of the film formation chamber 1 was evacuated. After that, the deposit sample 7 was taken out, and the amount of the etching was measured.

### [Examples 1-35]

Table 1 shows the cleaning object and the cleaning conditions in the present examples, and their measurement results of the etching rate. By setting the film formation chamber pressure at 2.7 kPa and using hexafluoroacetylacetone diluted to 50 volume % by N₂ as the cleaning gas, the cleaning tests were conducted by the above-mentioned operation at various temperatures against ZnO, Zn_{0.5}Mg_{0.5}O, Zn_{0.5}Mg_{0.5}OH_{0.1}, Zn₅OH, Mg_{0.5}OH, and MgO as the film compositions of the deposit samples 7 (Examples 1-24). As a result, it was found to be able to conduct the cleaning, in case that the temperature of the deposit sample 7 was any of 110 °C, 160 °C, 200 °C, and 380 °C.

Furthermore, it was also similarly possible to conduct the cleaning, in the case of repeating Example 3 except to change β-diketone to trifluoroacetylacetone (Example 25), in the case of repeating Example 3 except to change the diluting gas to O₂, Ar and their mixture (Examples 26-28), in the case of repeating Example 3 except to set the film formation chamber pressure at 40.0 kPa (Example 29), in the case of repeating Example 3 except to set the concentration of hexafluoroacetylacetone at 7, 15, 75, 85, and 100 volume % (Examples 30-34), and in the case of repeating Example 3 except to using as β-diketone one prepared by mixing equivalents of hexafluoroacetylacetone and trifluoroacetylacetone (Example 35).

**[Table 1]**

| Ex. | Deposit Composition | Pres. [kPa] | β-diketone | Diluting Gas | β-diketone Conc. [vol%] | Deposit Temp. [°C] | Etching Rate [nm/min] |
|---|---|---|---|---|---|---|---|
| 1 | ZnO | 2.7 | hexafluoroacetylacetone | N₂ | 50 | 110 | 90 |
| 2 | ZnO | 2.7 | hexafluoroacetylacetone | N₂ | 50 | 160 | 201 |
| 3 | ZnO | 2.7 | hexafluoroacetylacetone | N₂ | 50 | 200 | 235 |
| 4 | ZnO | 2.7 | hexafluoroacetylacetone | N₂ | 50 | 380 | 200 |
| 5 | Zn_{0.5}Mg_{0.5}O | 2.7 | hexafluoroacetylacetone | N₂ | 50 | 110 | 40 |
| 6 | Zn_{0.5}Mg_{0.5}O | 2.7 | hexafluoroacetylacetone | N₂ | 50 | 160 | 160 |
| 7 | Zn_{0.5}Mg_{0.5}O | 2.7 | hexafluoroacetylacetone | N₂ | 50 | 200 | 190 |
| 8 | Zn_{0.5}Mg_{0.5}O | 2.7 | hexafluoroacetylacetone | N₂ | 50 | 380 | 40 |
| 9 | Zn_{0.5}Mg_{0.5}OH_{0.1} | 2.7 | hexafluoroacetylacetone | N₂ | 50 | 110 | 42 |
| 10 | Zn_{0.5}Mg_{0.5}OH_{0.1} | 2.7 | hexafluoroacetylacetone | N₂ | 50 | 160 | 173 |
| 11 | Zn_{0.5}Mg_{0.5}OH_{0.1} | 2.7 | hexafluoroacetylacetone | N₂ | 50 | 200 | 201 |
| 12 | Zn_{0.5}Mg_{0.5}OH_{0.1} | 2.7 | hexafluoroacetylacetone | N₂ | 50 | 380 | 185 |
| 13 | Zn_{0.5}OH | 2.7 | hexafluoroacetylacetone | N₂ | 50 | 110 | 101 |
| 14 | Zn_{0.5}OH | 2.7 | hexafluoroacetylacetone | N₂ | 50 | 160 | 221 |
| 15 | Zn_{0.5}OH | 2.7 | hexafluoroacetylacetone | N₂ | 50 | 200 | 243 |
| 16 | Zn_{0.5}OH | 2.7 | hexafluoroacetylacetone | N₂ | 50 | 380 | 213 |
| 17 | Mg_{0.5}OH | 2.7 | hexafluoroacetylacetone | N₂ | 50 | 110 | 48 |
| 18 | Mg_{0.5}OH | 2.7 | hexafluoroacetylacetone | N₂ | 50 | 160 | 154 |
| 19 | Mg_{0.5}OH | 2.7 | hexafluoroacetylacetone | N₂ | 50 | 200 | 214 |
| 20 | Mg_{0.5}OH | 2.7 | hexafluoroacetylacetone | N₂ | 50 | 380 | 43 |
| 21 | MgO | 2.7 | hexafluoroacetylacetone | N₂ | 50 | 110 | 40 |
| 22 | MgO | 2.7 | hexafluoroacetylacetone | N₂ | 50 | 160 | 140 |
| 23 | MgO | 2.7 | hexafluoroacetylacetone | N₂ | 50 | 200 | 200 |
| 24 | MgO | 2.7 | hexafluoroacetylacetone | N₂ | 50 | 380 | 30 |
| 25 | ZnO | 2.7 | trifluoroacetylacetone | N₂ | 50 | 200 | 15 |
| 26 | ZnO | 2.7 | hexafluoroacetylacetone | O₂ | 50 | 200 | 245 |
| 27 | ZnO | 2.7 | hexafluoroacetylacetone | Ar | 50 | 200 | 225 |
| 28 | ZnO | 2.7 | hexafluoroacetylacetone | Ar+O₂ (25 vol% for each) | 50 | 200 | 235 |
| 29 | ZnO | 40.0 | hexafluoroacetylacetone | N₂ | 50 | 200 | 280 |
| 30 | ZnO | 2.7 | hexafluoroacetylacetone | N₂ | 7 | 200 | 18 |
| 31 | ZnO | 2.7 | hexafluoroacetylacetone | N₂ | 15 | 200 | 54 |
| 32 | ZnO | 2.7 | hexafluoroacetylacetone | N₂ | 75 | 200 | 262 |
| 33 | ZnO | 2.7 | hexafluoroacetylacetone | N₂ | 85 | 200 | 275 |
| 34 | ZnO | 2.7 | hexafluoroacetylacetone | N₂ | 100 | 200 | 280 |
| 35 | ZnO | 2.7 | hexafluoroacetylacetone + trifluoroacetylacetone (25 volume % for each) | N₂ | 50 | 200 | 200 |

### [Comparative Examples 1-13]

Table 2 shows the cleaning object and the cleaning conditions in the present comparative examples, and their measurement results of the etching rate. By setting the film formation chamber pressure at 2.7 kPa and using N₂ as the diluting gas, the cleaning tests were conducted by the above-mentioned operation against ZnO, Zn_{0.5}Mg_{0.5}O, MgO, Zn_{0.5}Mg_{0.5}OH_{0.1}, Zn_{0.5}OH, and Mg_{0.5}OH as the film compositions of the deposit samples 7 by setting the temperature of each deposit sample 7 at 90 °C or 420 °C. As a result, the film of the deposit sample 7 was not removed either in case that β-diketone was not contained in the cleaning gas (Comparative Example 1) or in case that the temperature of the deposit sample 7 was 90 °C or 420 °C.

**[Table 2]**

| Com. Ex. | Deposit Composition | Pres. [kPa] | β-diketone | Diluting Gas | β-diketone Conc. [vol%] | Deposit Temp. [°C] | Etching Rate [nm/min] |
|---|---|---|---|---|---|---|---|
| 1 | ZnO | 2.7 | - | N₂ | 0 | 200 | <5 |
| 2 | ZnO | 2.7 | hexafluoroacetylacetone | N₂ | 50 | 90 | <5 |
| 3 | ZnO | 2.7 | hexafluoroacetylacetone | N₂ | 50 | 420 | <5 |
| 4 | Zn_{0.5}Mg_{0.5}O | 2.7 | hexafluoroacetylacetone | N₂ | 50 | 90 | <5 |
| 5 | Zn_{0.5}Mg_{0.5}O | 2.7 | hexafluoroacetylacetone | N₂ | 50 | 420 | <5 |
| 6 | MgO | 2.7 | hexafluoroacetylacetone | N₂ | 50 | 90 | <5 |
| 7 | MgO | 2.7 | hexafluoroacetylacetone | N₂ | 50 | 420 | <5 |
| 8 | Zn_{0.5}Mg_{0.5}O | 2.7 | hexafluoroacetylacetone | N₂ | 50 | 90 | <5 |
| 9 | Zn_{0.5}Mg_{0.5}OH_{0.1} | 2.7 | hexafluoroacetylacetone | N₂ | 50 | 420 | <5 |
| 10 | Zn_{0.5}OH | 2.7 | hexafluoroacetylacetone | N₂ | 50 | 90 | <5 |
| 11 | Zn_{0.5}OH | 2.7 | hexafluoroacetylacetone | N₂ | 50 | 420 | <5 |
| 12 | Mg_{0.5}OH | 2.7 | hexafluoroacetylacetone | N₂ | 50 | 90 | <5 |
| 13 | Mg_{0.5}OH | 2.7 | hexafluoroacetylacetone | N₂ | 50 | 420 | <5 |

### INDUSTRIAL APPLICABILITY

The present invention can be used for cleaning an apparatus (e.g., CVD apparatus, sputtering apparatus, and vacuum deposition apparatus) for forming a composition represented by a general formula of Mg_{X}Zn_{1-X}O (0≤x≤1) into a film. In particular, it is effective when cleaning at low temperatures a composition represented by a compositional formula of MgₐZn_{b}OH_{c} (0≤a≤1, 0≤b≤1, 0≤c≤1, and 0.5≤a+b≤1) accumulated in the film formation chamber and in the exhaust pipe of the film formation apparatus, without opening the apparatus.

### DESCRIPTION OF THE SYMBOLS

- 1: a film formation chamber
- 21: a β-diketone supply system
- 22: a diluting gas supply system
- 31, 32, 33: valves
- 41, 42: gals pipes
- 5: a stage
- 61, 62: heaters
- 7: a deposit sample
- 8: a vacuum pump

## Claims

1. In a dry cleaning method for removing a composition represented by a compositional formula of MgₐZn_{b}OH_{c} (0≤a≤1, 0≤b≤1, 0≤c≤1, and 0.5≤a+b≤1), which accumulates in a film formation chamber or in an exhaust pipe of an apparatus for forming a composition represented by a compositional formula of MgxZn_{1-X}O (0≤x≤1) into a film, by using a cleaning gas, the dry cleaning method being **characterized by** that a cleaning gas containing β-diketone is used and that the composition is removed by reacting the composition accumulated with the cleaning gas at a temperature of from 100 °C to 400 °C.

2. The dry cleaning method as claimed in claim 1, which is **characterized by** that the β-diketone is hexafluoroacetylacetone or trifluoroacetylacetone.

3. The dry cleaning method as claimed in claim 1 or claim 2, which is **characterized by** that the cleaning gas contains at least one gas selected from the group consisting of He, Ar, N₂, and O₂.
